# EUROPEAN PATENT APPLICATION

(11) **EP 2 985 369 A1**
(43) Date of publication of application: **17.02.2016**
(21) Application number: 14782347.0
(22) Date of filing: 09.04.2014
(51) Int. Cl.: C30B 29/36, C30B 19/10, H01L 21/208

(54) **METHOD FOR MANUFACTURING SiC SINGLE CRYSTAL**

(30) Priority: 09.04.2013 JP 2013081376; 09.04.2013 JP 2013081382
(71) Applicant: Nippon Steel & Sumitomo Metal Corporation, Tokyo 100-8071 (JP); TOYOTA JIDOSHA KABUSHIKI KAISHA, Toyota-shi, Aichi-ken, 471-8571 (JP)
(72) Inventor: KUSUNOKI, Kazuhiko, Tokyo 100-8071 (JP); KAMEI, Kazuhito, Tokyo 100-8071 (JP); DAIKOKU, Hironori, Toyota-shi Aichi 471-8571 (JP); SAKAMOTO, Hidemitsu, Toyota-shi Aichi 471-8571 (JP); KADO, Motohisa, Toyota-shi Aichi 471-8571 (JP)
(74) Representative: Jackson, Martin Peter
(86) International application number: PCT/JP2014/002016
(87) International publication number: WO 2014/167844

(57) **Abstract**

The present invention provides a method for producing a SiC single crystal, which allows improving the quality of the single crystal even when crystal growth is performed by forming a meniscus. A growth step in the production method according to the present embodiment comprises a forming step and a first maintenance step. In the forming step, a meniscus is formed between a growth interface of a SiC single crystal and a liquid surface of a Si-C solution. In the first maintenance step, the fluctuation range of the height of the meniscus is maintained within a predetermined range by moving at least one of a seed shaft and a crucible relative to the other in the height direction.

## Description

### TECHNICAL FIELD

The present invention relates to a method for producing a SiC single crystal, and specifically to a method for producing a SiC single crystal by a solution growth method.

### BACKGROUND ART

One of methods for producing a SiC single crystal is a solution growth method. The solution growth method is disclosed in, for example, International Application Publication No. WO2010/024392 (Patent Literature 1), International Application Publication No. WO2012/127703 (Patent Literature 2), and Japanese Patent Application Publication No. 2012-184120 (Patent Literature 3). In the solution growth method disclosed in those literatures, a SiC seed crystal made of a SiC single crystal is brought into contact with a Si-C solution. The Si-C solution refers to a solution in which carbon (C) has dissolved in a melt of Si or Si alloy. The Si-C solution is brought into a supercooled state in a vicinity of the SiC seed crystal, thereby causing a SiC single crystal to grow on a surface (crystal growth plane) of the SiC seed crystal.

In the production method disclosed in Patent Literature 2, a meniscus is formed between the crystal growth plane of the SiC seed crystal and the liquid surface of the Si-C solution upon producing a SiC single crystal.

### CITATION LIST

### PATENT LITERATURE

Patent Literature 1: International Application Publication No. WO2010/024392
Patent Literature 2: International Application Publication No. WO2012/127703
Patent Literature 3: Japanese Patent Application Publication No. 2012-184120

### SUMMARY OF INVENTION

In recent years, studies have been conducted to increase the thickness of a SiC single crystal to be formed on the crystal growth plane of a SiC seed crystal. To increase the thickness of a SiC single crystal, it is necessary to increase the growth rate of the SiC single crystal or to increase the growth time of the SiC single crystal.

The present inventors have conducted diligent studies on how to increase the growth time of a SiC single crystal. Consequently, they have obtained the following findings.

When the growth time of a SiC single crystal increases, the liquid surface of the Si-C solution falls. This is due to the progress of growth of the SiC single crystal. Other reasons include, for example, evaporation of the Si-C solution. The speed at which the liquid surface of the Si-C solution falls often becomes larger than a speed at which a growth interface of the SiC single crystal moves downward as the crystal grows.

In Patent Literature 2, a meniscus is formed between the crystal growth plane of the SiC seed crystal and the liquid surface of the Si-C solution. In this case, as the SiC single crystal grows, the height of the meniscus increases. As the height of the meniscus increases, the degree of supersaturation (which refers to the degree of supersaturation with SiC, and the same applies hereafter) of the Si-C solution in a vicinity of the SiC seed crystal increases. When the degree of supersaturation excessively increases, inclusions become more likely to be formed in the SiC single crystal, thus deteriorating the quality of the SiC single crystal.

It is an object of the present invention to provide a method for producing a SiC single crystal, which allows suppressing deterioration of the quality of single crystal even when crystal growth is performed for long hours with a meniscus being formed.

The method for producing a SiC single crystal according an embodiment of the present invention produces a SiC single crystal by a solution growth method. The production method includes a preparation step, a generation step, and a growth step. In the preparation step, a production apparatus, which includes a crucible in which a raw material of a Si-C solution is contained and a seed shaft to which a SiC seed crystal is attached, is prepared. In the generation step, the raw material in the crucible is heated and melted to generate a Si-C solution. In the growth step, the SiC seed crystal is brought into contact with the Si-C solution, causing a SiC single crystal to grow on the SiC seed crystal. The growth step includes a forming step and a first maintenance step. In the forming step, a meniscus is formed between a growth interface of the SiC single crystal and a liquid surface of the Si-C solution. In the first maintenance step, a fluctuation range of the height of the meniscus is maintained within a predetermined range by moving at least one of the seed shaft and the crucible relative to the other in the height direction.

The method for producing a SiC single crystal according to an embodiment of the present invention can suppress deterioration of the quality of SiC single crystal.

### BRIEF DESCRIPTION OF DRAWINGS

[FIG. 1] FIG. 1 is a schematic diagram of a production apparatus to be used in a method for producing a SiC single crystal according to an embodiment of the present invention.
[FIG. 2] FIG. 2 is a schematic diagram to show a meniscus to be formed between a crystal growth plane of a SiC seed crystal and a Si-C solution.
[FIG. 3] FIG. 3 is a schematic diagram to show a meniscus to be formed between a growth interface of a SiC single crystal to be grown on the crystal growth plane of a SiC seed crystal and a Si-C solution.
[FIG. 4] FIG. 4 is a photograph to show a surface of the SiC single crystal relating to Inventive Example 1 of the present invention.
[FIG. 5] FIG. 5 is a photograph to show a surface of the SiC single crystal relating to Inventive Example 2 of the present invention.
[FIG. 6] FIG. 6 is a photograph to show a surface of the SiC single crystal relating to Comparative Example 1.
[FIG. 7] FIG. 7 is a photograph to show a surface of the SiC single crystal relating to Comparative Example 2.

### DESCRIPTION OF EMBODIMENTS

A method for producing a SiC single crystal according to an embodiment of the present invention produces a SiC single crystal by a solution growth method. The production method includes a preparation step, a generation step, and a growth step. In the preparation step, a production apparatus, which includes a crucible for containing a raw material of a Si-C solution and a seed shaft to which a SiC seed crystal is attached, is prepared. In the generation step, the raw material in the crucible is heated and melted to generate a Si-C solution. In the growth step, the SiC seed crystal is brought into contact with the Si-C solution, causing a SiC single crystal to grow on the SiC seed crystal. The growth step includes a forming step and a first maintenance step. In the forming step, a meniscus is formed between a growth interface of the SiC single crystal and a liquid surface of the Si-C solution. In the first maintenance step, a fluctuation range of the height of the meniscus is maintained within a predetermined range by moving at least one of the seed shaft and the crucible relative to the other in the height direction.

In the above described production method, a fluctuation range of the height of the meniscus is maintained within a predetermined range when a SiC single crystal is grown. Therefore, it is possible to suppress variation of the degree of supersaturation of the Si-C solution in a vicinity of the SiC seed crystal, caused by the fluctuation of the height of meniscus. As a result, a stable growth of a SiC single crystal is realized. That is, according to the above described production method, it is possible to suppress deterioration of the quality of SiC single crystal.

The above described growth interface of the SiC single crystal includes not only a growth interface of the SiC single crystal to be grown on the crystal growth plane of the SiC seed crystal, but also a crystal growth plane of the SiC seed crystal when the SiC single crystal is not growing on the crystal growth plane of the SiC seed crystal.

In the first maintenance step of the above described production method, at least one of the seed shaft and the crucible may be moved relative to the other in the height direction based on both a growth thickness of the SiC single crystal as a function of elapsed time and a fluctuation quantity of a liquid surface height of the Si-C solution in the growth step.

In this case, a step of determining a growth thickness of SiC single crystal as a function of elapsed time based on a growth thickness of a sample SiC single crystal which has been grown under the same condition as when the SiC single crystal is grown in the growth step may be further provided.

In the first maintenance step of the above described production method, at least one of the seed shaft and the crucible may be moved relative to the other in the height direction based on both a growth thickness of the SiC single crystal as a function of elapsed time and a fluctuation quantity of the liquid surface height of the Si-C solution as a function of elapsed time.

In this case, a step of determining a growth thickness of SiC single crystal as a function of elapsed time based on a growth thickness of a sample SiC single crystal which has been grown under the same condition as when the SiC single crystal is grown in the growth step, and a step of determining a fluctuation quantity of the liquid surface height of the Si-C solution as a function of elapsed time based on the fluctuation quantity of the liquid surface height of the sample Si-C solution used for growing the sample SiC single crystal may be further provided.

Preferably, the production apparatus further includes a high-frequency coil. The high-frequency coil is disposed around the side wall of the crucible. The growth step may further include a second maintenance step of moving at least one of the crucible and the high-frequency coil relative to the other in the height direction, and maintaining the fluctuation range of the separation distance in the height direction between the liquid surface of the Si-C solution and a height center of the high-frequency coil within a predetermined range.

Increasing the growth time of a SiC single crystal will result in fall of the liquid surface of the Si-C solution. This is due to the progress of growth of the SiC single crystal. Other reasons include, for example, evaporation of the Si-C solution.

In the high-frequency coil disposed as described above, heating temperature differs in the height direction.

Falling of the liquid surface of the Si-C solution will result in variation of the positional relationship between the liquid surface of the Si-C solution and the high-frequency coil. For that reason, the temperature in a region in a vicinity of the SiC seed crystal (hereafter, referred to as a vicinity region) in the Si-C solution will vary. And variation of the temperature of the vicinity region will result in variation of the degree of supersaturation of the vicinity region. In this case, the SiC single crystal is not likely to grow in a stable manner. For that reason, the quality of the SiC single crystal deteriorates.

In the production method of the present embodiment, when a SiC single crystal is grown, the fluctuation range of the above described separation distance is maintained within a predetermined range. In this case, the heating condition of the Si-C solution by the high-frequency coil is not likely to vary. For that reason, the temperature variation in the vicinity region will be suppressed, and thereby variation in the degree of supersaturation in the vicinity region is suppressed. As a result, the SiC single crystal grows in a stable manner, and the quality of the SiC single crystal improves.

In the second maintenance step of the above described production method, at least one of the crucible and the high-frequency coil may be moved in the height direction relative to the other based on the fluctuation quantity of the liquid surface height of the Si-C solution.

In the second maintenance step of the above described production method, at least one of the crucible and the high-frequency coil may be moved in the height direction relative to the other based on the fluctuation quantity of the liquid surface height of the Si-C solution as a function of elapsed time.

In this case, the above described production method may further include a step of growing a sample SiC single crystal under the same growth condition as that of the SiC single crystal in the growth step, and a step of determining a fluctuation quantity of the liquid surface height of the Si-C solution as a function of elapsed time based on the fluctuation quantity of the liquid surface height of the sample Si-C solution used when the sample SiC single crystal has been grown.

Hereafter, referring to the drawings, embodiments of the present invention will be described. Like parts or corresponding parts in the figures are given the like symbols, and the description thereof will not be repeated.

### [First Embodiment]

The method for producing a SiC single crystal according to a first embodiment of the present invention is based on a solution growth method. The present production method includes a preparation step, a generation step, and a growth step. In the preparation step, a production apparatus is prepared. In the generation step, a Si-C solution is generated. In the growth step, a SiC seed crystal is brought into contact with the Si-C solution, causing a SiC single crystal to grow. Hereafter, each step will be described in detail.

### [Preparation Step]

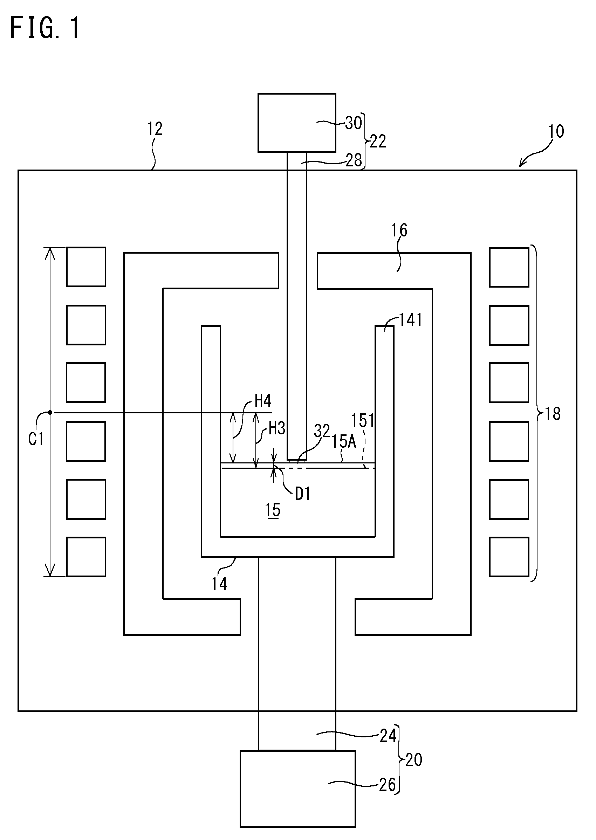

In the preparation step, a production apparatus to be used for the solution growth method is prepared. FIG. 1 is a schematic diagram of a production apparatus 10 to be used in the method for producing a SiC single crystal according to an embodiment of the present invention. Note that the production apparatus 10 shown in FIG. 1 is an example of the production apparatus to be used in the solution growth method. Therefore, the production apparatus to be used in the solution growth method will not be limited to the production apparatus 10 shown in FIG. 1.

The production apparatus 10 includes a chamber 12, a crucible 14, a heat insulation member 16, a heating apparatus 18, a rotating apparatus 20, and a lifting apparatus 22.

The chamber 12 contains the crucible 14. When producing a SiC single crystal, the chamber 12 is cooled.

The crucible 14 contains a raw material for a Si-C solution 15. Preferably, the crucible 14 contains carbon. In this case, the crucible 14 serves as a carbon supply source for the Si-C solution 15.

The heat insulation member 16 is made of a heat insulation material and is configured to surround the crucible 14.

The heating apparatus 18 is for example a high-frequency coil and is configured to surround the side wall of the heat insulation member 16. The heating apparatus 18 inductively heats the crucible 14, and generates the Si-C solution 15. The heating apparatus 18 further maintains the Si-C solution 15 at a crystal growth temperature. The crystal growth temperature is temperature of the Si-C solution 15 when causing the SiC single crystal to grow. The crystal growth temperature is, for example, 1600 to 2000°C, and preferably 1900 to 2000°C.

The rotating apparatus 20 includes a rotation shaft 24 and a driving source 26.

The rotation shaft 24 extends in the height direction (up-and-down direction of FIG. 1) of the chamber 12. The upper end of the rotation shaft 24 is located within the heat insulation member 16. The crucible 14 is disposed at the upper end of the rotation shaft 24. The lower end of the rotation shaft 24 is located outside the chamber 12.

The driving source 26 is disposed below the chamber 12. The driving source 26 is connected to the rotation shaft 24. The driving source 26 rotates the rotation shaft 24 about the central axis of the rotation shaft 24.

The lifting apparatus 22 includes a seed shaft 28 and a driving source 30.

The seed shaft 28 extends in the height direction of the chamber 12. An upper end of the seed shaft 28 is located outside the chamber 12. A SiC seed crystal 32 is attached to the lower end surface of the seed shaft 28.

The driving source 30 is disposed above the chamber 12. The driving source 30 is connected to the seed shaft 28. The driving source 30 raises and lowers the seed shaft 28. The driving source 30 rotates the seed shaft 28 about the central axis of the seed shaft 28.

In the preparation step, further, a SiC seed crystal 32 is prepared. The SiC seed crystal 32 is made of a SiC single crystal. Preferably, the crystal structure of the SiC seed crystal 32 is the same as that of the SiC single crystal to be produced. For example, when a SiC single crystal of 4H polytype is to be produced, a SiC seed crystal 32 of 4H polytype is used. When a SiC seed crystal 32 of 4H polytype is used, it is preferable that the crystal growth plane be (0001) plane or (000-1) plane, or a plane which is inclined by not more than 8° from (0001) plane or (000-1) plane. In such a case, the SiC single crystal will grow in a stable manner.

When the production apparatus 10 and the SiC seed crystal 32 are made ready, the SiC seed crystal 32 is attached to the lower end surface of the seed shaft 28.

Next, the crucible 14 is disposed on the rotation shaft 24 in the chamber 12. At this moment, the crucible 14 contains a raw material for the Si-C solution 15. The raw material is, for example, Si , or a mixture of Si and another metal element. The metal element includes, for example, titanium (Ti), manganese (Mn), chromium (Cr), cobalt (Co), vanadium (V), iron (Fe), and the like. The raw material is, for example, in the form of multiple lumps, powder, and the like.

### [Generation Step]

Next, the Si-C solution 15 is generated. First, the chamber 12 is filled with an inert gas. Then, the raw material for the Si-C solution 15 in the crucible 14 is heated to not less than the melting point thereof by the heating apparatus 18. When the crucible 14 is made of graphite, heating the crucible 14 causes carbon to dissolve into the melt from the crucible 14, generating the Si-C solution 15. As carbon of the crucible 14 dissolves into the Si-C solution 15, the carbon concentration in the SiC solution 15 reaches a saturated concentration.

### [Growth Step]

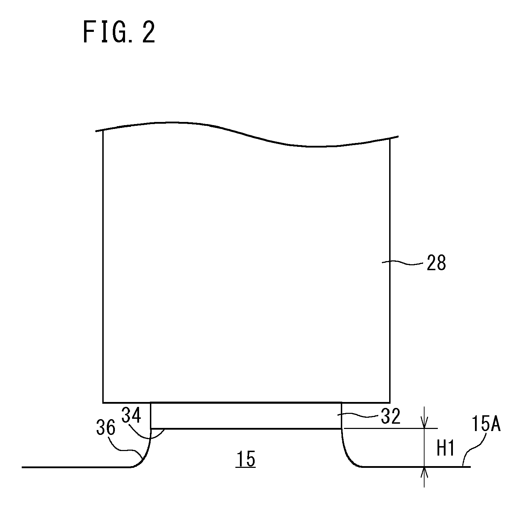

Next, the seed shaft 28 is lowered by the driving source 30 so at to bring the SiC seed crystal 32 into contact with the Si-C solution 15. After the SiC seed crystal 32 is brought into contact with the Si-C solution 15, the seed shaft 28 is raised. This results in formation of a meniscus 36 between a crystal growth plane 34 of the SiC seed crystal 32 and a liquid surface 15A of the Si-C solution 15, as shown in FIG. 2 (forming step). A height H1 of the meniscus 36 in an initial stage of crystal growth is defined by the difference in height between the crystal growth plane 34 and the liquid surface 15A.

After the meniscus 36 is formed, the Si-C solution 15 is kept at the crystal growth temperature by the heating apparatus 18. Further, the Si-C solution 15 is supercooled in the vicinity of the SiC seed crystal 32 so as to be supersaturated with SiC.

The method for supercooling the vicinity of the SiC seed crystal 32 will not be particularly limited. For example, the heating apparatus 18 is controlled to make the temperature of the vicinity region of the SiC seed crystal 32 lower than that of other regions. Alternatively, the vicinity of the SiC seed crystal 32 may be cooled by a cooling medium. Specifically, the cooling medium is recirculated inside the seed shaft 28. The cooling medium is an inert gas, such as helium (He), argon (Ar), and the like. Recirculating the cooling medium inside the seed shaft 28 will cause the SiC seed crystal 32 to be cooled. When the SiC seed crystal 32 is cooled, the region in the vicinity of the SiC seed crystal 32 will be cooled as well.

While keeping the vicinity region of the SiC seed crystal 32 being supersaturated with SiC(solid), the SiC seed crystal 32 and the Si-C solution 15 (the crucible 14) are rotated. Rotating the seed shaft 28 causes the SiC seed crystal 32 to rotate. And rotating the rotation shaft 24 causes the crucible 14 to rotate. The rotation direction of the SiC seed crystal 32 may be the opposite direction to, or the same direction as the rotation direction of the crucible 14. Moreover, the rotating speed may be constant or may be varied. At this moment, a SiC single crystal is generated and grows on the crystal growth plane 34 of the SiC seed crystal 32 which is brought into contact with the Si-C solution 15. Note that the seed shaft 28 needs not to be rotated.

Increasing the growth time allows increasing the thickness of the SiC single crystal formed on the crystal growth plane 34. Increasing the growth time causes the liquid surface of the Si-C solution 15 to fall. That is because the growth of SiC single crystal progresses on the crystal growth plane 34 of the SiC seed crystal 34. Other reasons include, for example, that the Si-C solution 15 evaporates, and that as a result of carbon dissolving into the Si-C solution 15 from the crucible 14, the thickness of the crucible 14 is reduced, thereby increasing the volume of the crucible 14. For that reason, the speed at which the liquid surface of the Si-C solution 15 falls often becomes larger than the speed at which the growth interface of the SiC single crystal moves downward as the crystal grows. As a result, the height of a meniscus formed between the growth interface of the SiC single crystal and the liquid surface of the Si-C solution 15 often increases.

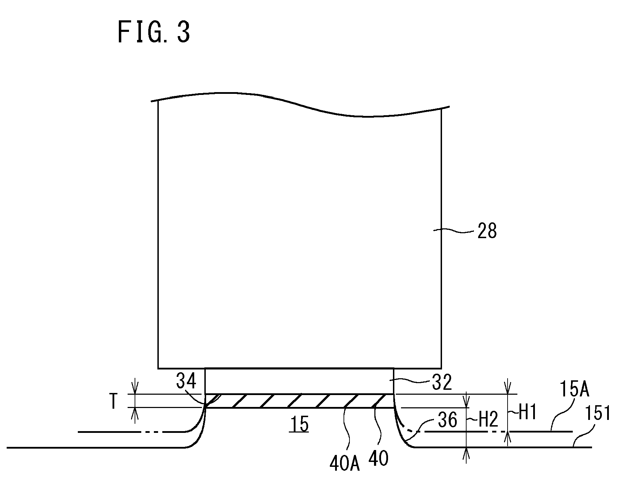

Referring to FIG. 3, the fluctuation of the height of the meniscus associated with the growth of SiC single crystal will be described. Upon elapse of a predetermined time after the initiation of crystal growth, a SiC single crystal 40 having a thickness T is formed on the crystal growth plane 34. Moreover, as the SiC single crystal 40 grows, a liquid surface 151 of the Si-C solution 15 becomes lower than the liquid surface 15A when the crystal growth is initiated. A height H2 of the meniscus 36 when the growth of SiC single crystal 40 is in progress is defined by the difference in height between the growth interface 40A of the SiC single crystal 40 and the liquid surface 151 of the Si-C solution 15.

As described above, the speed at which the liquid surface 151 falls often becomes larger than the speed at which the growth interface 40A moves downward. For that reason, the height H2 of the meniscus 36 during crystal growth often becomes larger than the height H1 (see FIG. 2) of the meniscus 36 of the initial stage of crystal growth.

As the height H2 of the meniscus 36 increases to be larger than the height H1 of the initial stage, the degree of supersaturation of the Si-C solution 15 in the vicinity of the SiC seed crystal 32 increases. When the degree of supersaturation excessively increases, inclusions become likely to be formed, thus deteriorating the quality of the SiC single crystal 40.

In the present production method, the SiC single crystal 40 is grown while maintaining the fluctuation range (difference between the height H2 during growth and the height H1 in the initial stage) of the height of the meniscus 36 to be within a predetermined range. As a result, it is possible to suppress variation of the degree of supersaturation in the vicinity region of the SiC seed crystal 32, caused by fluctuation of the height of meniscus 36. As a result, formation of inclusions is suppressed and a stable growth of SiC single crystal 40 is realized. Therefore, even when crystal growth is performed for long hours with the meniscus 36 being formed, it is possible to suppress deterioration of the quality of the SiC single crystal 40.

In addition, an expansion angle of the SiC single crystal 40 becomes less likely to vary. As a result, it is possible to grow the SiC single crystal 40 with a target size.

The height H2 of the meniscus 36 during growth may become smaller or larger than the height H1 of the initial stage. When the height H2 of the meniscus 36 during growth becomes smaller than the height H1 of the initial stage, the fluctuation range of the height of the meniscus 36 (the difference between the height H2 during growth and the height H1 in the initial stage) is preferably not more than 1.0 mm and less than H1, more preferably not more than 0.7 mm and less than H1, more preferably not more than 0.5 mm and less than H1, and further preferably not more than 0.3 mm and less than H1. When the height H2 of the meniscus 36 during growth becomes larger than the height H1 of the initial stage, the fluctuation range of the height of the meniscus 36 (the difference between height H2 during growth and height H1 in the initial stage) is preferably not more than 1.0 mm, more preferably not more than 0.7 mm, more preferably not more than 0.5 mm, and further preferably not more than 0.3 mm.

To control the fluctuation range of the height of the meniscus 36 during growth within the above described range, at least one of the seed shaft 28 and the crucible 14 is moved relative to the other. Specific methods include: (1) method of moving the seed shaft 28 closer to/away from the crucible 14, (2) method of moving the crucible 14 closer to/away from the seed shaft 28, and (3) method of moving the seed shaft 28 closer to/away from the crucible 14, and moving the crucible 14 closer to/away from the seed shaft 28.

The height H2 of the meniscus 36 during growth is the difference in height between the growth interface 40A and the liquid surface 151. Therefore, as one way to determine the height H2 of the meniscus 36 during growth, the position of the growth interface 40A and the position of the liquid surface 151 (which refer to positions in the height direction, and the same applies hereafter) may be determined.

To determine the position of the growth interface 40A, for example, a step of determining a growth thickness of the SiC single crystal 40 according to time (elapsed time) from the initiation of crystal growth may be further provided. This step is performed prior to the above described growth step.

Specifically, first, a sample SiC single crystal is grown under the same growth condition as when the SiC single crystal 40 is grown in the above described growth step. Next, a growth thickness per unit time of the sample SiC single crystal is determined by dividing the growth thickness of the sample SiC single crystal by a sample growth time. Thus obtained growth thickness per unit time of the sample SiC single crystal is set to the growth thickness per unit time of the SiC single crystal 40.

Multiplying thus set growth thickness per unit time of the SiC single crystal 40 by an elapsed time allows determining a growth thickness T of the SiC single crystal 40 as a function of the elapsed time. That is, the position of the growth interface 40A is determined.

It is not necessary to determine the growth thickness per unit time of the SiC single crystal 40 to determine the position of the growth interface 40A. For example, the growth thickness of the SiC single crystal 40 at any other elapsed time may be estimated from the growth thickness of the SiC single crystal 40 at a certain elapsed time. In this case, the position of the growth interface 40A is determined from the estimated growth thickness. The growth thickness per unit time of the SiC single crystal 40 and the growth thickness of the SiC single crystal 40 as a function of elapsed time may be determined by simulation. When the growth condition of the SiC single crystal 40 is changed, they may be estimated from the data which have been obtained before.

For example, a step of determining a fluctuation quantity of the liquid surface height as a function of elapsed time may be provided to determine the position of the liquid surface 151. This step is performed prior to the above described growth step.

Specifically, first, a sample SiC single crystal is grown under the same growth condition as when the SiC single crystal 40 is grown in the above described growth step.

Next, the position (which refers to the position in the height direction, and the same applies hereafter) of the liquid surface of the sample Si-C solution to be used for growing of the sample SiC single crystal is determined. Specifically, the position of the liquid surface at the time of initiation of sample growth, and the position of the liquid surface after the end of sample growth are determined.

To determine the position of the liquid surface at the time of initiation of sample growth, for example, the following method is available. First, a sample SiC solution is generated. Next, the generated sample Si-C solution is solidified without causing the sample SiC single crystal to grow. Then, the position of the surface of the solidified sample Si-C solution is set to the position of the liquid surface at the time of initiation of sample growth.

The method for determining the position of the liquid surface at the time of initiation of sample growth is not limited to the above described method. For example, the following method is available. First, a sample SiC single crystal is grown. Next, the sample Si-C solution is solidified. Then, with reference to a trace of the sample Si-C solution which appears on the inner peripheral surface of the crucible, the position of the liquid surface at the time of initiation of sample growth is set.

To determine the position of the liquid surface after the end of sample growth, for example, the following method is available. First, a sample Si-C solution is generated. Next, the sample Si-C solution is solidified. Then, the position of the surface of the solidified sample Si-C solution is set to the position of the liquid surface after the end of sample growth.

Next, the difference between the position of the liquid surface at the time of initiation of sample growth and the position of the liquid surface after the end of sample growth is determined. The thus determined difference between the liquid surface positions is divided by a sample growth time. As a result of this, a fluctuation quantity of the liquid surface height of the sample Si-C solution per unit time is obtained. This is set to the fluctuation quantity of the liquid surface height of the Si-C solution 15 per unit time.

The thus set fluctuation quantity of the liquid surface height of the Si-C solution 15 per unit time is multiplied by the time (elapsed time) from the initiation of crystal growth. As a result of this, the fluctuation quantity of liquid surface height of the Si-C solution 15 as a function of the elapsed time is determined.

Moreover, the position of liquid surface of the sample Si-C solution at the time of initiation of growth of the sample SiC single crystal, which has been determined as described above, is set to the position of liquid surface of the Si-C solution 15 at the time of initiation of growth of the SiC single crystal 40.

The fluctuation quantity of liquid surface height of the Si-C solution 15 as a function of elapsed time, which has been determined as described above, is subtracted from the thus set position of liquid surface of the Si-C solution 15 at the time of initiation of the SiC single crystal 40. As a result of this, the position of the liquid surface 151 is determined.

Note that the method for determining the position of the liquid surface 151 will not be limited to the above described method. For example, the position of the liquid surface 151 may be determined by simulation. Moreover, when the growth condition of the SiC single crystal 40 is changed, it may be estimated from the data which have been obtained before.

It is not necessary to determine the fluctuation quantity of liquid surface height of the sample Si-C solution per unit time to determine the fluctuation quantity of liquid surface height of the Si-C solution 15 as a function of elapsed time. For example, the fluctuation quantity of liquid surface height of the Si-C solution 15 as a function of elapsed time may be determined by estimation from the time of initiation of sample growth and the position of the liquid surface of the sample Si-C solution at a certain elapsed time.

Moreover, the position of the liquid surface 151 may be actually measured. In such a case, the method for measuring the position of the liquid surface 151 includes, for example, a method of optically detecting it in a non-contact fashion and a method of electrically detecting it by bringing a jig into contact with the liquid surface 151. The method of optical detection in a non-contact fashion is, for example, based on the principle of trigonometry. The position of the liquid surface 151 is determined by utilizing the liquid surface 151 as a direct reflector. In the method of electrical detection, for example, a jig made of a conductive material (for example, a bar made of graphite), which is electrically insulated from the chamber 12, is lowered to be brought into contact with the liquid surface 151. If voltage is applied to the jig in this situation, electric conduction occurs when the jig comes into contact with the liquid surface 151. For example, when a pair of jigs are provided, electric conduction occurs between the pair of jigs. Alternatively, electric conduction may occur between one of the jigs and the seed shaft 28. The position of the liquid surface 151 is detected based on the position of the jig when electric conduction occurs. Upon detection of the position of the liquid surface 151, the jig is raised to be separated from the liquid surface 151. After elapse of a predetermined time, the jig is lowered again to detect the position of the liquid surface 151. The jig used at this time is preferably different from that used in the previous detection. This is because there is risk that accurate detection of the liquid surface position cannot be done with the jig used in the previous detection due to adhesion and solidification of the Si-C solution 15 onto the jig.

The difference between the position of the growth interface 40A and the position of the liquid surface 151, which has been determined as described above, is set to the height H2 of the meniscus 36 during growth. Further, the difference between the height H2 during growth and the height H1 of the initial stage is set to the fluctuation range of the height of the meniscus 36 during growth. At least one of the seed shaft 28 and the crucible 14 is moved relative to the other such that the fluctuation range falls within a predetermined range (specifically, the above described range). As a result of this, stable growth of the SiC single crystal 40 can be realized.

Note that the production method according to the first embodiment of the present invention is not limited to the above described production method provided that the fluctuation range of the height H2 of the meniscus 36 while the SiC single crystal 40 is grown is within the predetermined range.

### [Second Embodiment]

As described above, increasing the growth time allows growing the SiC single crystal to be thick, but on the other hand causes the liquid surface of the Si-C solution to fall.

Falling of the liquid surface of the Si-C solution 15 will result in deviation of the positional relationship between the liquid surface and the high-frequency coil 18. For that reason, the heating condition of the Si-C solution 15 by the high-frequency coil 18 is likely to vary. Hereafter, this point will be described.

The high-frequency coil 18 is a tubular air-core coil, and is disposed in such a way to surround the crucible 14 as shown in FIG. 1. The heating temperature at a center position C1 in the height of the high-frequency coil 18 is higher than the heating temperature at an upper or lower end of the high-frequency coil 18. That is, the heating temperature of the high-frequency coil 18 differs in the height direction of the high-frequency coil 18. For that reason, when the growth of the SiC single crystal progresses and if the liquid surface 15A of the Si-C solution 15 falls, the positional relationship between the high-frequency coil 18 and the liquid surface 15A will vary. In such a case, the heating condition of the Si-C solution 15 by the high-frequency coil 18 may vary.

Variation of the heating condition of the Si-C solution 15 by the high-frequency coil 18 results in variation of the temperature of the vicinity region of the SiC seed crystal 32. And variation of the temperature of the vicinity region causes variation of the degree of supersaturation with SiC of the vicinity region. When the degree of supersaturation deviates from an appropriate range, inclusions become more likely to be generated, thus deteriorating the quality of the SiC single crystal.

Accordingly, in the growth step of the present embodiment, the fluctuation range (H3 - H4 = D1) of the separation distance in the height direction between the liquid surface of the Si-C solution 15 and the height center C1 of the high-frequency coil 18 is further maintained within a predetermined range (see FIG. 1), while maintaining the fluctuation range of the meniscus within a predetermined range X1 as in the first embodiment. In such a case, the positional relationship between the high-frequency coil 18 and the liquid surface of the Si-C solution 15 is maintained within a predetermined range X2. Therefore, variation of the heating condition of the Si-C solution 15 will be suppressed. As a result, generation of inclusions is suppressed, thereby improving the quality of the SiC single crystal. Note that the predetermined range X1 and the predetermined range X2 may be the same value, or different values.

The separation distance H3 in the height direction between the liquid surface 151 during crystal growth and the height center C1 may become smaller or larger than the separation distance H4 in the height direction between the liquid surface 15A in the initial stage of crystal growth and the height center C 1. When the separation distance H3 during crystal growth becomes smaller than the separation distance H4 in the initial stage, the fluctuation range D1 is preferably not more than 1.0 mm, more preferably not more than 0.5 mm, and further preferably not more than 0.2 mm. When the separation distance H3 during growth becomes larger than the separation distance H4 in the initial stage, the fluctuation range D1 is preferably not more than 1.0 mm, more preferably not more than 0.5 mm, and further preferably not more than 0.2 mm.

To facilitate understanding, in FIG. 1, the height center C1 is located at a position higher than the liquid surface 15A in the initial stage of crystal growth. In the initial stage of crystal growth, the height center C1 may be located at the same height as the liquid surface 15A.

To control the fluctuation range D1 within the predetermined range, at least one of the crucible 14 and the high-frequency coil 18 is moved relative to the other in the height direction based on the fluctuation range D1. Specific methods include: (1) method of moving the high-frequency coil 18 relative to the crucible 14 in the height direction, (2) method of moving the crucible 14 relative to the high-frequency coil 18 in the height direction, and (3) method of moving the high-frequency coil 18 relative to the crucible 14 in the height direction, and moving the crucible 14 relative to the high-frequency coil 18 in the height direction.

As one way to control the fluctuation range D1 within the above described range, for example, the position of the liquid surface of the Si-C solution 15 may be determined.

To determine the position of the liquid surface of the Si-C solution 15, for example, a step (setting step) of setting a fluctuation quantity of the liquid surface height of the Si-C solution 15 as a function of elapsed time may be further provided. This step is performed prior to the above described growth step. How to determine the fluctuation quantity of the liquid surface height as a function of elapsed time is, for example, as described in the first embodiment.

The difference between the position of the liquid surface of the Si-C solution 15 as a function of elapsed time and the position of the liquid surface of the Si-C solution 15 in the initial stage is defined as a fluctuation range D1. At least one of the crucible 14 and the high-frequency coil 18 is moved relative to the other such that the fluctuation range D1 is within a predetermined range (specifically, the above described range). As a result of this, even when the growth time becomes large, stable growth of the SiC single crystal can be realized.

In the above described second embodiment, in the growth step, the fluctuation range of the height of the meniscus is controlled to be within the predetermined range X1, and further the fluctuation range D1 is controlled to be within the predetermined range X2. However, in the growth step, the fluctuation range D1 may be controlled to be within the predetermined range, without controlling the fluctuation range of the meniscus height.

The production method according to the second embodiment will not be limited to the above described production method provided that the fluctuation range of the height of the meniscus and the fluctuation range D1 are controlled within predetermined ranges.

In the second embodiment, a high-frequency coil 18 is utilized as the heating apparatus. However, the heating apparatus may be any other heating apparatus other than the high-frequency coil 18.

### EXAMPLE 1

The fluctuation range of the meniscus height in the growth step was altered to produce 4 kinds of SiC single crystals (Example 1, Example 2, Comparative Example 1, and Comparative Example 2). The quality of the produced SiC single crystals was evaluated.

### [Production condition of Inventive Example 1]

The composition of the raw material of Si-C solution was, in atomic ratio, Si : Cr = 0.6 : 0.4. The temperature of the Si-C solution in the vicinity of the SiC seed crystal (crystal growth temperature) was 1850°C. The temperature gradient in the vicinity of the SiC seed crystal was 15°C/cm. The SiC seed crystal was a SiC seed crystal of 4H polytype. The crystal growth plane of the SiC seed crystal was (000-1) plane. After the SiC seed crystal was brought into contact with the Si-C solution, the SiC seed crystal was pulled up by 1.0 mm to form a meniscus between the crystal growth plane of the SiC seed crystal and the Si-C solution. That is, the meniscus height when the crystal growth was initiated was 1.0 mm. The seed shaft was lowered after an elapsed time of 5 hours from the initiation of crystal growth. The lowering speed of the seed shaft in the growth step was 0.1 mm/hr. The lowering speed of the seed shaft was set such that the fluctuation range of the meniscus height was 0.3 mm. Specifically, the lowering speed of the seed shaft was set based on the growth thickness of the sample SiC single crystal and the fall amount of the liquid surface of the sample Si-C solution, when the sample SiC single crystal was produced under the same production condition. The growth time was 20 hours. That is, the time period in which the seed shaft was lowered was 15 hours. The lowered amount of the seed shaft was 1.5 mm.

### [Production condition of Inventive Example 2]

The production condition of Inventive Example 2 differed in the lowering speed of the seed shaft, when compared with the production condition of Inventive Example 1. Specifically, the lowering speed of the seed shaft was 0.06 mm/hr. The lowering speed of the seed shaft was set such that the fluctuation range of the meniscus height was 0.7 mm. Specifically, the lowering speed was set based on the growth thickness of the sample SiC single crystal, and the fall amount of the liquid surface of the sample Si-C solution when the sample SiC single crystal was produced under the same production condition. The time period in which the seed shaft was lowered was 15 hours. The lowered amount of the seed shaft was 0.9 mm. Other production conditions of Inventive Example 2 were the same as in Inventive Example 1.

### [Production condition of Comparative Example 1]

In the production condition of Comparative Example 1, the seed shaft was retained at the same position during crystal growth, when compared with the production condition of Inventive Example 1. Other production conditions of Comparative Example 1 were the same as those of Inventive Example 1.

### [Production condition of Comparative Example 2]

In the production condition of Comparative Example 2, the seed shaft was raised instead of being lowered, when compared with the production condition of Inventive Example 1. The raising speed of the seed shaft was 0.1 mm/hr. Other production conditions were the same as in Inventive Example 1.

### [Evaluation method]

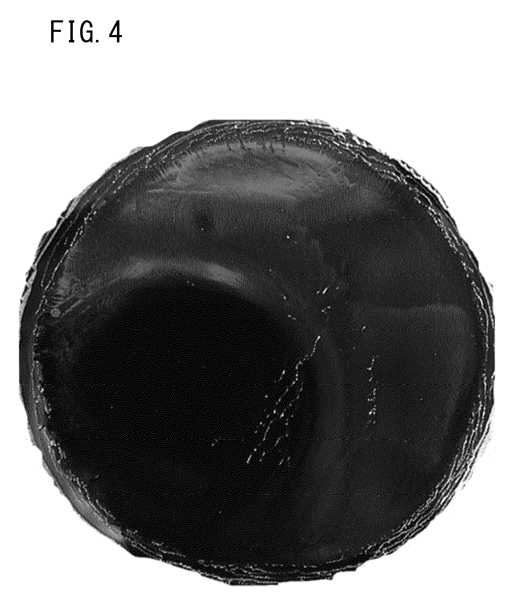

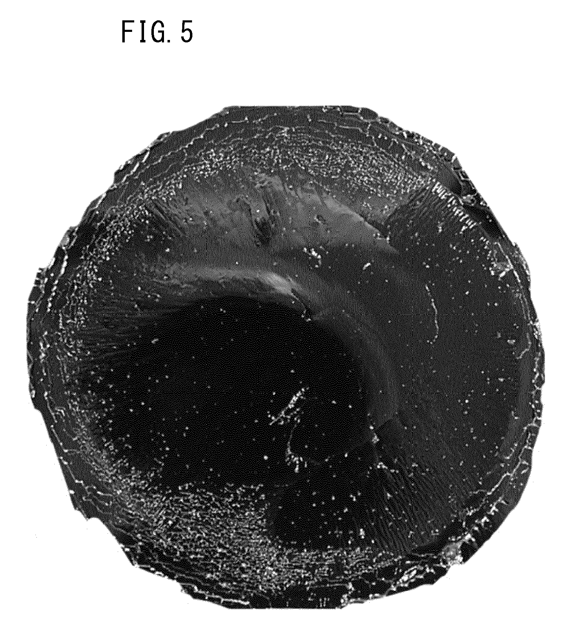

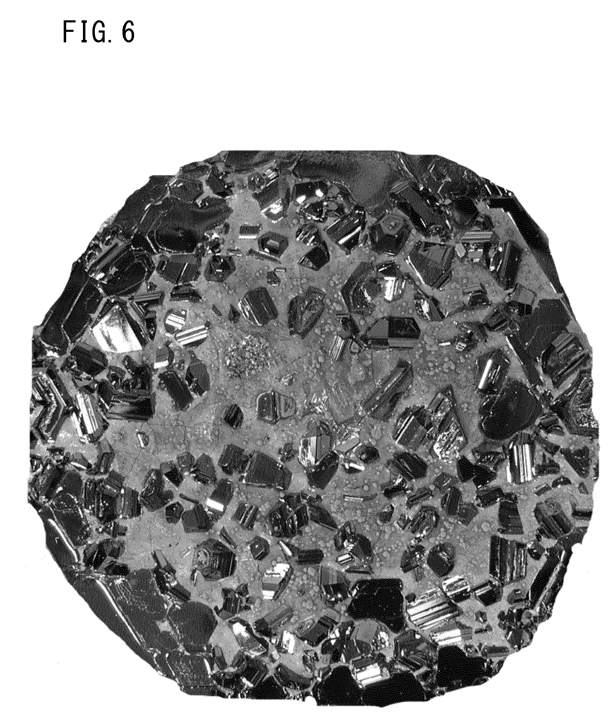

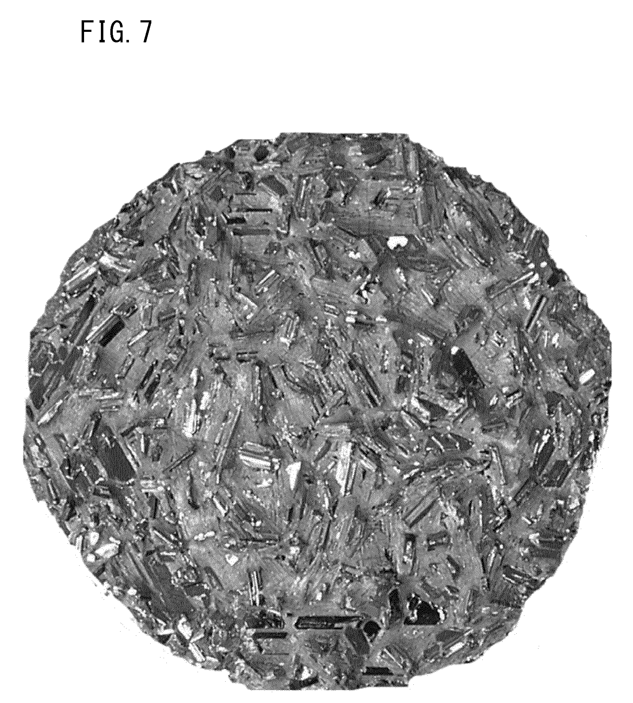

The surface of each of the produced SiC single crystals was observed with an optical microscope. The results thereof are shown in FIGS. 4 to 7. FIG. 4 is a photograph to show a surface of a SiC single crystal relating to Inventive Example 1. FIG. 5 is a photograph to show a surface of a SiC single crystal relating to Inventive Example 2. FIG. 6 is a photograph to show a surface of the SiC single crystal relating to Comparative Example 1. FIG. 7 is a photograph to show a surface of the SiC single crystal relating to Comparative Example 2.

The SiC single crystal was cut in the crystal growth direction to measure the growth thickness of a SiC single crystal which had grown well. Specifically, a polished cut plane (observation surface) was observed with an optical microscope. In the observation surface, SiC polycrystals were excluded from thickness measurement. Further, portions of SiC single crystal including incorporations of solvent (inclusions) were excluded from thickness measurement. In observation surfaces, the growth thickness of any SiC single crystal which was confirmed to be free from inclusions was measured. The confirmation of polycrystals and inclusions was performed at a magnification of 100 times.

The fall amount of the liquid surface of the Si-C solution was measured based on a trace of the Si-C solution formed on the inner peripheral surface of the crucible. The fluctuation range of the meniscus height was determined based on the fall amount of the liquid surface of the Si-C solution, the thickness of SiC single crystal, and the displacement amount of the seed shaft. Specifically, when the seed shaft was lowered (Inventive Examples 1 and 2), the thickness of the SiC single crystal and the displacement amount of the seed shaft were subtracted from the fall amount of the liquid surface of the Si-C solution. When the seed shaft was raised (Comparative Example 2), after the thickness of the SiC single crystal was subtracted from the fall amount of the liquid surface of the Si-C solution, the displacement amount of the seed shaft was added thereto. The results are shown in Table 1. Note that, in Comparative Examples 1 and 2, since polycrystals had grown on the surface (growth interface) of the SiC single crystal, it was not possible to measure the thickness of the SiC single crystal. For that reason, the thickness of the SiC single crystal of Example 1 was used as the thickness of the SiC single crystal to be used for determining the fluctuation range of the meniscus height.

**[Table 1]**

| | Fall amount of liquid surface of Si-C solution (mm) | Growth thickness of SiC single crystal (mm) | Displacement amount of seed shaft (mm) ("+" indicates lowering, and "-" indicates rising) | Fluctuation range of meniscus height (mm) |
|---|---|---|---|---|
| Inventive Example 1 | 3.8 | 2.0 | 1.5 | 0.3 |
| Inventive Example 2 | 3.8 | 2.2 | 0.9 | 0.7 |
| Comparative Example 1 | 3.8 | - | ±0 | >1.8 |
| Comparative Example 2 | 3.8 | - | -2.0 | >3.8 |

The fluctuation ranges of the meniscus height of Inventive Examples 1 and 2 were the same as an intended fluctuation range. These are both smaller than the meniscus height in the initial stage. Therefore, the fluctuation ranges of the meniscus height of Inventive Examples 1 and 2 were within the scope of the present invention.

The fluctuation ranges of the meniscus height of Comparative Examples 1 and 2 were larger than the meniscus height in the initial stage. Therefore, the fluctuation ranges of the meniscus height of Comparative Examples 1 and 2 were out of the scope of the present invention.

Referring to FIGS. 4 to 7, the surface of each produced SiC single crystal was flatter in Inventive Examples 1 and 2 compared with in Comparative Examples 1 and 2. In Inventive Examples 1 and 2, the thickness of any SiC single crystal which contained no inclusions was not less than 2.0 mm. On the other hand, in Comparative Examples 1 and 2, any SiC single crystal which contained no inclusions was not produced. Therefore, those results confirmed that the quality of SiC single crystal was improved according to the production method of Inventive Example of the present invention.

### EXAMPLE 2

The fluctuation range of the separation distance in the height direction between the liquid surface of the Si-C solution when a SiC single crystal was grown and the height center of the high-frequency coil was altered to produce 5 kinds of SiC single crystals (Inventive Example 3, Inventive Example 4, Inventive Example 5, and Comparative Example 3). Then, the quality of each produced SiC single crystal was evaluated.

### [Production condition of Inventive Example 3]

The composition of the raw material of Si-C solution was, in atomic ratio, Si : Cr = 0.6 : 0.4. The temperature of the Si-C solution in the vicinity of the SiC seed crystal (crystal growth temperature) was 1940°C. The temperature gradient in the vicinity of the SiC seed crystal was 15°C/cm. The SiC seed crystal was a SiC seed crystal of 4H polytype. The crystal growth plane of the SiC seed crystal was (000-1) plane. After the SiC seed crystal was brought into contact with the Si-C solution, the SiC seed crystal was pulled up by 0.5 mm to form a meniscus between the crystal growth plane of the SiC seed crystal and the liquid surface of the Si-C solution. That is, the meniscus height when the crystal growth was initiated was 0.5 mm. The high-frequency coil was lowered after an elapsed time of 5 hours from the initiation of crystal growth. The lowering speed of the high-frequency coil was 0.2 mm/hr. The lowering speed of the high-frequency coil was set such that the fluctuation range of the separation distance in the height direction between the liquid surface of the Si-C solution and the height center of the high-frequency coil was 0.2 mm. Specifically, the lowering speed of the high-frequency coil was set based on the fall amount of the liquid surface of the sample Si-C solution when the sample SiC single crystal was produced under the same production condition. The growth time was 25 hours. That is, the time period in which the high-frequency coil was lowered was 20 hours.

### [Production condition of Inventive Example 4]

The production condition of Inventive Example 4 differed in the lowering speed of the high-frequency coil, when compared with the production condition of Inventive Example 3. Further, in Inventive Example 4, the crucible was raised in conjunction with the lowering of the high-frequency coil. The lowering speed of the high-frequency coil was 0.1 mm/hr. The raising speed of the crucible was 0.1 mm/hr. The lowering speed of the high-frequency coil and the raising speed of the crucible were set such that the fluctuation range of the separation distance in the height direction between the liquid surface of the Si-C solution and the height center of the high-frequency coil was 0.2 mm. Specifically, the lowering speed of the high-frequency coil and the raising speed of the crucible were set based on the fall amount of the liquid surface of the sample Si-C solution when the sample SiC single crystal was produced under the same production condition. Other conditions were the same as those of Inventive Example 3.

### [Production condition of Inventive Example 5]

The production condition of Inventive Example 5 differed in that the seed shaft was lowered, when compared with the production condition of Inventive Example 3. The lowering of the seed shaft was performed in conjunction with the lowering of the high-frequency coil. The lowering speed of the seed shaft was 0.025 mm/hr. The lowering speed of the seed shaft was set such that the fluctuation range of the meniscus height was 0.3 mm. Specifically, the lowering speed of the seed shaft was set based on the growth thickness of the sample SiC single crystal and the fall amount of the liquid surface of the sample Si-C solution when the sample SiC single crystal was produced under the same production condition. Other conditions of Inventive Example 5 were the same as those of Inventive Example 3.

### [Production condition of Comparative Example 3]

The production condition of Comparative Example 3 differed in that the high-frequency coil was not lowered, when compared with the production condition of Inventive Example 3. That is, in the growth step, all of the high-frequency coil, the crucible, and the seed shaft were located at the same positions. Other conditions of Comparative Example 3 were the same as those of Inventive Example 3.

### [Evaluation method]

The growth thickness of each SiC single crystal which contained no inclusions among Inventive Examples 3 to 5 and Comparative Example 3 was measured by the same method as in Example 1. Measurement results are shown in Table 2.

The symbol "E" (Excellent) in the evaluation column of Table 2 means that the growth thickness of a SiC single crystal containing no inclusions was not less than 3.5 mm. The symbol "G" (Good) means that the growth thickness was 2.5 to less than 3.5 mm. The symbol "NA" (Not Acceptable) means that the growth thickness was less than 2.5 mm.

Further, in Inventive Examples 3 to 5 and Comparative Example 3, the fluctuation range of the separation distance in the height direction between the liquid surface of the Si-C solution and the height center of the high-frequency coil, and the fluctuation range of the meniscus height were determined. Results thereof are shown in Table 2. The fall amount of the liquid surface of the Si-C solution which was used for determining those fluctuation ranges was measured based on the trace of the Si-C solution formed on the inner peripheral surface of the crucible.

The fluctuation range of the separation distance in the height direction between the liquid surface of the Si-C solution and the height center of the high-frequency coil was determined by the following method. For Inventive Examples 3 and 5, the above described fluctuation range was supposed to be the difference between the lowered amount of the high-frequency coil and the fall amount of the liquid surface of the Si-C solution. For Inventive Example 4, the above described fluctuation range was supposed to be the difference between the relative moving distance of the high-frequency coil with respect to the crucible, and the fall amount of the liquid surface of the Si-C solution. For Comparative Example 3, the above described fluctuation range was supposed to be the fall amount of the liquid surface of the Si-C solution.

The fluctuation range of the meniscus height was determined by the following way. For Inventive Example 3 and Comparative Example 3, the fluctuation range of the meniscus height was supposed to be the value of the fall amount of the liquid surface of the Si-C solution subtracted by the growth thickness of the SiC single crystal. For Inventive Example 4, the fluctuation range of the meniscus height was supposed to be the value of the fall amount of the liquid surface of the Si-C solution subtracted by the growth thickness of the SiC single crystal and the raised amount of the crucible. For Inventive Example 5, the fluctuation range of the meniscus height was supposed to be the value of the fall amount of the liquid surface of the Si-C solution subtracted by the growth thickness of the SiC single crystal and the lowered amount of the seed shaft.

**[Table 2]**

| | Lowered amount of high-frequency coil (mm) | Raised amount of crucible (mm) | Lowered amount of seed shaft (mm) | Fall amount of liquid surface of Si-C solution (mm) | Growth thickness of SiC single crystal (mm) | Fluctuation range of meniscus height (mm) | Fluctuation range D1 (mm) | Evaluation |
|---|---|---|---|---|---|---|---|---|
| Inventive Example 3 | 4.0 | 0.0 | 0.0 | 3.8 | 2.9 | 0.9 | 0.2 | G |
| Inventive Example 4 | 2.0 | 2.0 | 0.0 | 3.8 | 2.8 | 1.0 | 0.2 | G |
| Inventive Example 5 | 4.0 | 0.0 | 0.5 | 3.8 | 3.6 | 0.3 | 0.2 | E |
| Comparative Example 3 | 0.0 | 0.0 | 0.0 | 4.0 | 1.5 | 2.5 | 4.0 | NA |

The surface of each produced SiC single crystal was flatter in Inventive Examples 3 to 5 compared with in Comparative Example 3. In Comparative Example 3, SiC polycrystals were grown on the surface of the produced SiC single crystal.

Further, in Inventive Examples 3 to 5, the thickness of a SiC single crystal which contained no inclusions was larger compared with in Comparative Example 3. Particularly, in Inventive Example 5, the thickness of a SiC single crystal which contained no inclusions was larger than in Inventive Examples 3 and 4. These results confirmed that the quality of SiC single crystal was improved by the production method of Inventive Examples of the present invention.

While embodiments of the present invention have been described in detail so far, they are merely exemplifications and the present invention will by no means be limited by those embodiments.

For example, the raw material of the Si-C solution may be added while the SiC single crystal is being grown. In such a case, the liquid surface of the Si-C solution rises. The present invention may be applied to a case where the liquid surface of the Si-C solution rises.

## Claims

1. A method for producing a SiC single crystal by a solution growth method, comprising:
a preparation step of preparing a production apparatus including a crucible in which a raw material of a Si-C solution is contained, and a seed shaft to which a SiC seed crystal is attached;
a generation step of heating and melting the raw material in the crucible and generating the Si-C solution; and
a growth step of bringing the SiC seed crystal into contact with the Si-C solution to cause the SiC single crystal to grow on the SiC seed crystal, wherein
the growth step includes:
a forming step of forming a meniscus between a growth interface of the SiC single crystal and a liquid surface of the Si-C solution; and
a first maintenance step of maintaining a fluctuation range of a height of the meniscus within a predetermined range by moving at least one of the seed shaft and the crucible relative to the other in a height direction.

2. The production method according to claim 1, wherein
in the first maintenance step, at least one of the seed shaft and the crucible is moved relative to the other in the height direction based on both a growth thickness of the SiC single crystal as a function of elapsed time and a fluctuation quantity of a liquid surface height of the Si-C solution in the growth step.

3. The production method according to claim 2, further comprising:
a step of determining a growth thickness of the SiC single crystal as a function of the elapsed time based on a growth thickness of a sample SiC single crystal which has been grown under a same condition as when the SiC single crystal is grown in the growth step.

4. The production method according to claim 1, wherein
in the first maintenance step, at least one of the seed shaft and the crucible is moved relative to the other in the height direction based on both a growth thickness of the SiC single crystal as a function of elapsed time and a fluctuation quantity of the liquid surface height of the Si-C solution as a function of the elapsed time.

5. The production method according to claim 4, further comprising:
a step of determining a growth thickness of the SiC single crystal as a function of the elapsed time based on a growth thickness of a sample SiC single crystal which has been grown under the same condition as when the SiC single crystal is grown in the growth step, and
a step of determining a fluctuation quantity of a liquid surface height of the Si-C solution as a function of the elapsed time based on a fluctuation quantity of the liquid surface height of a sample Si-C solution used for growing the sample SiC single crystal.

6. The production method according to any one of claims 1 to 5, wherein
the production apparatus further includes a high-frequency coil disposed around a side wall of the crucible, and
the growth step further includes a second maintenance step of moving at least one of the crucible and the high-frequency coil relative to the other in the height direction, and maintaining a fluctuation range of a separation distance in the height direction between a liquid surface of the Si-C solution and a height center of the high-frequency coil within a predetermined range.

7. The production method according to claim 6, wherein
in the second maintenance step, at least one of the crucible and the high-frequency coil is moved in the height direction relative to the other based on a fluctuation quantity of a liquid surface height of the Si-C solution.

8. The production method according to claim 7, wherein
in the second maintenance step, at least one of the crucible and the high-frequency coil is moved in the height direction relative to the other based on a fluctuation quantity of the liquid surface height of the Si-C solution as a function of elapsed time.

9. The production method according to claim 8, further comprising:
a step of growing a sample SiC single crystal under a same growth condition as that when the SiC single crystal is grown in the growth step, and
a step of determining a fluctuation quantity of the liquid surface height of the Si-C solution as a function of elapsed time based on a fluctuation quantity of a liquid surface height of a sample Si-C solution used when the sample SiC has been grown.
